# EUROPÄISCHE PATENTSCHRIFT

(11) **EP 3 411 186 B1**
(45) Veröffentlichungstag und Bekanntmachung des Hinweises auf die Patenterteilung: **21.07.2021**
(21) Anmeldenummer: 17701124.4
(22) Anmeldetag: 23.01.2017
(51) Int. Cl.: B25B 7/00

(54) **HANDWERKZEUG**
HAND TOOL
OUTIL À MAIN

(30) Priorität: 04.02.2016 DE 102016101925
(43) Veröffentlichungstag der Anmeldung: 12.12.2018
(73) Patentinhaber: Knipex-Werk C. Gustav Putsch KG, 42349 Wuppertal (DE)
(72) Erfinder: SCHLEIMINGER, Jan, 42697 Solingen (DE)
(74) Vertreter: Müller, Enno
(86) Internationale Anmeldenummer: PCT/EP2017/051315
(87) Internationale Veröffentlichungsnummer: WO 2017/133914

(56) Entgegenhaltungen:
- EP-A1- 2 179 820
- DE-U1- 20 120 379
- US-A1- 2005 081 687
- US-A1- 2014 013 544
- US-B1- 6 270 134

## Beschreibung

### Gebiet der Technik

Die Erfindung betrifft ein Handwerkzeug nach den Merkmalen des Oberbegriffes des Anspruches 1.

### Stand der Technik

Handwerkzeuge der in Rede stehenden Art sind bekannt, so bspw. in Form von Zangen, wie weiter bspw. Kombinationszangen, Seitenschneider oder auch Wasserpumpenzangen, darüber hinaus auch in Form von Scheren, weiter bspw. Haushaltsscheren oder Gartenscheren. Die Griffbereiche sind mit Griffhüllen versehen. Hierbei handelt es sich in der Regel um Kunststoff-Griffhüllen, weiter um solche, die im Kunststoff-Spritzverfahren hergestellt sein können. So sind diesbezüglich Handwerkzeuge bekannt, bei welchen die Griffhüllen gesondert hergestellt, insbesondere gespritzt sind und hiernach über die Griffbereiche aufgeschoben sind. Auch sind diesbezüglich Lösungen bekannt, bei welchen eine unmittelbare Umspritzung der Griffbereiche erfolgt. Darüber hinaus sind Griffhüllen bekannt, die im Zwei-Komponenten-Spritzverfahren hergestellt sind, entsprechend aufweisend greifgünstige Weich- und Hartkunststoffzonen. Auch können die Griffhüllen durch einen Tauchvorgang auf die Griffbereiche aufgebracht sein.

Es ist weiter bekannt, eine Griffhülle - und somit das Handwerkzeug insgesamt - mit einem Funktionsteil zu versehen. Dieses steht über die eigentliche Oberfläche der Griffhülle hinaus. Bekannt ist diesbezüglich die Anordnung des Funktionsteils in einem Bereich der Griffhülle, in welchem ein wesentlicher Teil der Oberfläche der Griffhülle sich in einer ebenen Fläche erstreckt. Eine solche ebene Fläche weist entsprechend bevorzugt keine vor- und rückspringenden Erhöhungen oder Vertiefungen auf, wobei jedoch eine solche ebene Fläche durchaus auch leicht gekrümmt verlaufen kann, dies bei entsprechend großem Krümmungsradius, der bspw. größer ist als 25 oder 50 mm. Der wesentliche Teil der Oberfläche der Griffhülle entspricht etwa einem Viertel bis einem Drittel der gesamten Oberfläche der Griffhülle, dies weiter insbesondere ausgehend von dem freien Griffende betrachtet.

Bekannte Ausbildungen sehen eine einstückige Ausgestaltung von Griffhülle und Funktionsteil vor.

Aus der US 6270134 B1 sind Griffhüllen für kreuzend zueinander angeordnete Werkzeughälften bekannt, die jeweils eine zweiteilige Griffhülle aufweisen, mit einer inneren Hülle und einer äußeren Hülle. Ein an der inneren Hülle angebrachtes Funktionsteil ragt durch ein Fenster der äußeren Hülle hindurch. Aus der US 2014/013544 A1 ist ein Schraubenschlüssel mit zwei durch einen einzigen Schaft verbundenen Arbeitsbereichen bekannt. Auf diesen Schaft ist eine den Schaft umgreifende Schlaufe aufgezogen und durch einseitigen Eingriff in die Schlaufe wiederum ein Band angeordnet, an welchem ein Bügel gehaltert sein kann.

### Zusammenfassung der Erfindung

Im Hinblick auf den genannten Stand der Technik beschäftigt sich die Erfindung mit der Aufgabenstellung eine günstige Ausgestaltung einer Zusammenfassung einer Griffhülle mit einem Funktionsteil anzugeben, ein Handwerkszeug der in Rede stehenden Art in vorteilhafter Weise weiter zu verbessern.

Diese Aufgabe ist beim Gegenstand des Anspruches 1 gelöst, wobei darauf abgestellt ist, dass aufeinander zu weisende Innenflächen der Griffhüllen, ausgehend von freien Enden der Griffbereiche, ebenflächig ausgebildet sind, dass das Funktionsteil auf der der Innenfläche der gegenüberliegenden zweiten und/oder ersten Griffhülle zugewandten Innenfläche der ersten und/oder zweiten Griffhülle angeordnet ist, und dass das Funktionsteil angeklebt oder angeschweißt ist, an einer Position, welche außerhalb eines Erfassungs- und Einwirkungsbereiches des Benutzers liegt.

Durch die vorgeschlagene Art der Befestigung des Funktionsteils an der einen Griffhülle ergibt sich insbesondere eine günstige Herstellung. Griffhülle und Funktionsteil werden bevorzug gesondert hergestellt. Eine Griffhülle wird mit einem entsprechenden Funktionsteil an der hierfür Position befestigt.

Darüber hinaus ist durch die vorgeschlagene Erfindung das Funktionsteil bezüglich Material (Härtegrad) und/oder Farbe unter Berücksichtigung der Befestigungsart (Kleben oder Schweißen) unabhängig vom gewählten Griffhüllenmaterial. So kann das Funktionsteil eine, wie bevorzugt, größere oder auch geringere Härte aufweisen als das Griffhüllenmaterial, insbesondere im Befestigungsbereich. So kann das Griffhüllenmaterial im Befestigungsbereich des Funktionsteiles beispielsweise eine Härte von 80 bis 90 Shore A aufweisen und das Material des Funktionsteiles beispielsweise eine Härte von 60 bis 70 Shore D. Es kann eine Härte des Funktionsteilmaterials vorliegen, die um etwa 10 bis 20 Shore-Grade oder mehr höher ist als die Härte des Griffhüllenmaterials.

Die Befestigung des Funktionsteils an der Griffhülle erfolgt durch Klebung oder durch Schweißung, insbesondere Ultraschallschweißen erreicht. Es kann eine Befestigungsart bevorzugt sein, die nicht zerstörungsfrei aufhebbar ist.

Es kann nur eine Griffhülle mit einem solchen Funktionsteil versehen sein. Auch können an einer Griffhülle mehrere Funktionsteile griffinnen- und/ oder griffaußenseitig vorgesehen sein. Darüber hinaus sind Handwerkzeuge möglich, deren beide Griffhüllen mit einem oder mehreren Funktionsteilen versehen sind.

Das Funktionsteil kann etwa ein Achtel bis ein Zwanzigstel des wesentlichen Teils der Oberfläche der Griffhülle einnehmen bzw. überdecken.

Das Funktionsteil ist auf der, der Innenfläche der gegenüberliegenden zweiten und/oder ersten Griffhülle zugewandten Innenfläche der ersten und/oder zweiten Griffhülle angeordnet. Entsprechend kann eine Positionierung des Funktionsteiles gewählt sein, welche weder die Verlagerungsmöglichkeit der Werkzeughälften beeinträchtigt, noch störend für den Benutzer beim Betätigen des Handwerkzeuges wirkt. Es ist eine Position gegeben, welche außerhalb des Erfassungs- und Einwirkungsbereiches durch den Benutzer liegt.

Das Funktionsteil weist darüber hinaus einen zur Verbindung mit der ersten und/oder zweiten Griffhülle ausgebildeten Verbindungsbereich auf, der als ebene Fläche oder rippen- oder noppenartig strukturiert ausgebildet ist. Eine ebene, insbesondere an den Oberflächenverlauf der Griffhülle im Verbindungsbereich angepasste Fläche, ggf. also auch gekrümmt verlaufende Fläche des Verbindungsbereiches, bietet sich insbesondere für eine Verklebung an. Zum Anschweißen, insbesondere im Ultraschall-Schweißverfahren, bietet sich eine rippen- oder noppenartige Strukturierung der der Oberfläche der Griffhülle zugewandten Flachseite des Verbindungsbereiches an, so dass eine punkt- oder linienförmige Schweißverbindung erreichbar ist.

Im Falle einer rippenartigen Strukturierung kann, wie auch bevorzugt, mindestens eine umlaufend geschlossene Rippe ausgebildet sein, dies mit Bezug auf eine Draufsicht auf die der Oberfläche der Griffhülle zur Befestigung zugewandte Oberfläche des Verbindungsbereiches. Der umlaufende Rippenverlauf kann, wie auch bevorzugt, angepasst sein an den Grundriss des Verbindungsbereiches.

In weiterer Ausgestaltung können mehrere solcher umlaufend geschlossenen Rippen in dem Verbindungsbereich vorgesehen sein, insbesondere in Form von konzentrisch angeordneten umlaufend geschlossenen Rippen.

In einer möglichen Ausgestaltung können zwei in Längsrichtung einer Griffhülle gesonderte Verbindungsbereiche ausgebildet sein. Diese Verbindungsbereiche können, wie auch bevorzugt, miteinander verbunden sein. Es ergeben sich lediglich an einem Funktionsteil zwei getrennte Bereiche zur Verbindung mit der Griffhülle. Bevorzugt erfolgt die Verbindung mittels Klebung oder Schweißung über beide Verbindungsbereiche. Je nach Funktion des Funktionsteiles kann aber auch nur einer der Verbindungsbereiche zur Festlegung genutzt sein.

Insgesamt kann das Funktionsteil eine langgestreckt, quaderförmige Gestaltung aufweisen. So können in einer Ausführungsform die beiden Verbindungsbereiche jeweils etwa quadratische Grundrisse aufweisen, die sich zu einem insgesamt langgestreckt rechteckigen Grundriss ergänzen.

Das Funktionsteil kann eine über die ebene Fläche der Oberfläche der Griffhülle überstehende Dicke aufweisen - gemessen quer zur Längserstreckung des Griffbereiches - die einem Zehntel bis zwei Drittel der Dickenabmessung des von der Griffhülle im Übrigen geschlossenen Griffbereiches im Bereich des Funktionsteiles entspricht. So kann bei einer beispielhaften Dicke des von der Griffhülle umfassten Bereichs des Griffes von 12 bis 15 mm eine Funktionsteildicke von 2 bis 4 mm vorliegen.

Das Funktionsteil kann als Fallsicherung ausgebildet sein, bspw. eine Öse oder dergleichen aufweisend zum Anbinden des Handwerkzeuges beispielsweise an einen Gürtel oder dergleichen. Auch kann das Funktionsteil eine Federaufnahme sein, bspw. zur Steckaufnahme eines freien Endes einer Blattfeder zur Rückstellung des Handwerkzeugs in eine vorgegebene Grundstellung. Darüber hinaus kann das Funktionsteil unmittelbar als Feder ausgebildet sein, bspw. als Rückstellfeder für das Handwerkzeug. In einer weiteren möglichen Ausgestaltung ist das Funktionsteil ein Bügelhalter. Ein solcher Bügel kann ein entsprechend geformter Drahtbügel sein, der weiter bspw. zwischen den beiden Verbindungsbereichen zwischen Funktionsteil und Griffhülle ggf. schwenkbewegbar gefasst sein kann. Durch das zunächst lose vorliegende Funktionsteil kann ein solcher Bügel quasi endlos ausgebildet sein, bspw. ein Drahtbügel mit verschweißten Enden. Darüber hinaus kann das Funktionsteil auch eine Aufnahme für einen Aufhängehaken oder dergleichen formen.

In weiterer Ausgestaltung kann das Funktionsteil eine Aufnahme oder Halterung für ein Technikteil bilden. Ein solches Technikteil kann bspw. ein Mess- oder Prüfteil sein, weiter bspw. ein Spannungsprüfer oder ein Messwerkzeug. Auch kann das Technikteil zur Aufnahme und/oder Halterung eines elektrischen oder elektronischen Bauteils dienen, bspw. ein Akkumulator oder ein vergleichbarer Energiespeicher.

In einer möglichen Ausgestaltung ist das Technikteil ein Transponder, bspw. ein RFID-Transponder. Dieser kann einen elektronischen Chip, bspw. Speicherchip zum Aufzeichnen von Events aufweisen oder mit diesem in bzw. an dem Funktionsteil gekoppelt sein. Der Transponder kann dabei über eine eigene Energieversorgung verfügen.

Das Technikteil kann gänzlich in dem Funktionsteil aufgenommen sein, bspw. bei Herstellung des Funktionsteils im Kunststoff-Spritzverfahren durch Umspritzen des Technikteils.

Auch kann das Technikteil in einer bspw. taschenartigen Vertiefung in dem Funktionsteil einliegen. Diese Vertiefung kann deckelverschlossen sein, wobei der Deckel auch allein durch die zugewandte Fläche des Zangengriffes oder der Griffhülle gebildet sein kann. Es kann eine Kammer in dem Funktionsteil ausgebildet sein, zur Aufnahme des Technikteils. Auch können mehrere Kammern zur Aufnahme mehrerer Technikteile vorgesehen sein oder eine Unterteilung der Vertiefung.

Zudem kann das Funktionsteil einen Adapter für ein Aufschiebe- oder Aufrastteil bilden. Das adapterartige Funktionsteil kann eine Grundform aufweisen, die mit Aufschiebe- oder Aufrastteilen unterschiedlicher Funktionen bestückbar ist. Das Aufschiebe- oder Aufrastteil kann bspw. eine der vorbeschriebenen, auch unmittelbar durch das Funktionsteil gegebenen Funktionen aufweisen.

Das Aufschiebe- oder Aufrastteil kann nach einem Ansetzen an den adapterseitigen Funktionsteil an diesem so festgelegt sein, dass dieses nicht oder zumindest nicht werkzeuglos, ggf. aber auch nicht zerstörungsfrei wieder entfernbar ist. In alternativer Ausgestaltung ist eine reversible Anordnung an dem Adapter möglich, um so das Handwerkzeug nach Bedarf mit dem einen oder anderen Aufschiebe- oder Aufrastteil zu bestücken.

Die vor- und nachstehend angegebenen Bereiche bzw. Wertebereiche oder Mehrfachbereiche schließen Offenbarung auch sämtliche Zwischenwerte ein, insbesondere in 1/10-Schritten der jeweiligen Dimension, ggf. also auch dimensionslos. Beispielsweise beinhaltet die Angabe 1/10 bis 2/3 auch die Offenbarung von 11/100 bis 2/3,1/10 bis 19/30, 11/100 bis 19/30 etc. Diese Offenbarung kann einerseits zu einer genannten Bereichsgrenze von unten und/oder oben, alternativ aber zur Offenbarung eines oder mehrerer singulärer Werte aus einem jeweilig angegebenen Bereich dienen.

### Kurze Beschreibung der Zeichnungen

Nachstehend ist die Erfindung anhand der beigefügten Zeichnung erläutert, die aber lediglich Ausführungsbeispiele darstellt. Ein Teil, das nur bezogen auf eines der Ausführungsbeispiele erläutert ist, und bei einem weiteren Ausführungsbeispiel aufgrund der dort herausgestellten Besonderheit nicht durch ein anderes Teil ersetzt ist, ist damit auch für dieses weitere Ausführungsbeispiel als jedenfalls mögliches vorhandenes Teil beschrieben. Auf der Zeichnung zeigt:
- Fig. 1: in perspektivischer Darstellung ein Handwerkzeug in Form einer Zange mit einem an einer Griffhülle des Handwerkzeuges angeordneten Funktionsteil in einer ersten Ausführungsform, sowie eine Vergrößerung des befestigten Funktionsteiles;
- Fig. 2: in perspektivischer Darstellung eine Griffhülle mit daran angeordnetem Funktionsteil;
- Fig. 3: eine perspektivische Ausschnittdarstellung der Griffhülle mit zugeordnetem, an der Griffhülle noch nicht befestigtem Funktionsteil;

- Fig. 4: das Funktionsteil der ersten Ausführungsform in perspektivischer Einzeldarstellung;
- Fig. 5: den Schnitt gemäß der Linie V-V in Figur 2;
- Fig. 6: das Funktionsteil der ersten Ausführungsform in Draufsicht;
- Fig. 7: das Funktionsteil in Unteransicht;
- Fig. 8: den Schnitt gemäß der Linie VIII-VIII in Figur 5;
- Fig. 9: eine der Figur 5 entsprechende Schnittdarstellung, eine Verschwenkposition eines an dem Funktionsteil schwenkbeweglich gehalterten Bügels betreffend;
- Fig. 10: eine Schnittdarstellung durch ein Funktionsteil in einer zweiten Ausführungsform;
- Fig. 11: eine der Figur 10 entsprechende Schnittdarstellung, eine dritte Ausführungsform des Funktionsteiles betreffend,
- Fig. 12: eine vierte Ausführungsform des Funktionsteiles in einer Schnittdarstellung gemäß Figur 10;
- Fig. 13: eine der Figur 6 entsprechende Darstellung, eine weitere Ausführungsform betreffend;
- Fig. 14: die Unteransicht zu Figur 13;
- Fig. 15: die Ausführungsform gemäß Figur 13 in einer Schnittdarstellung gemäß Figur 9;
- Fig. 16: eine weitere der Figur 9 entsprechende Schnittdarstellung, betreffend eine weitere Ausführungsform.

### Beschreibung der Ausführungsformen

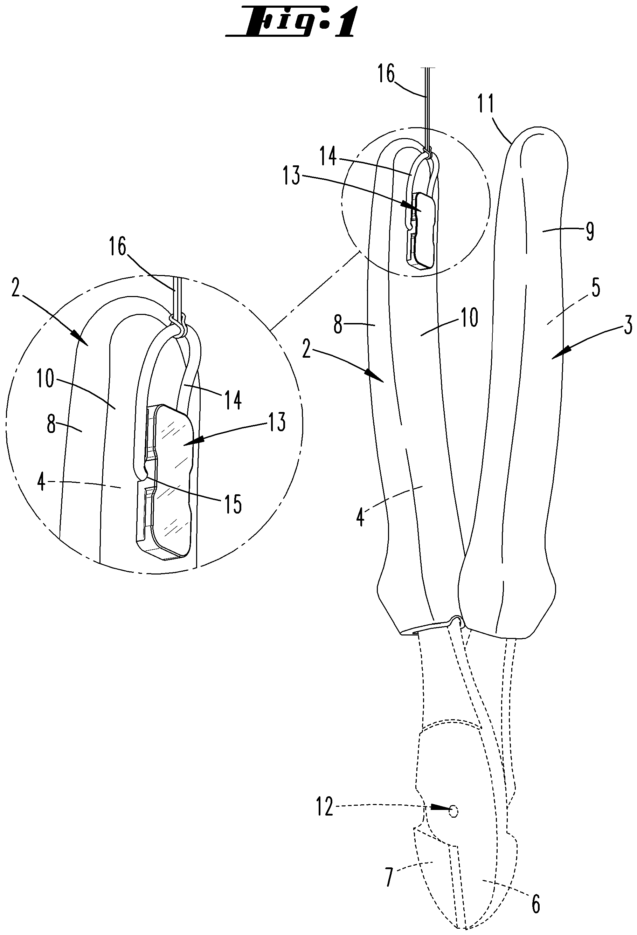

Dargestellt und beschrieben ist, zunächst mit Bezug zu Figur 1, ein Handwerkzeug 1 in Form einer Zange, weiter insbesondere in Form eines Seitenschneiders. Die nachfolgenden Ausführungen beziehen sich jedoch nicht nur auf ein solches Handwerkzeug, sondern insbesondere auch auf weitere Zangen, wie beispielsweise Flachzangen, Wasserpumpenzangen, Kombinationszangen oder dergleichen, darüber hinaus bspw. auch auf Scheren, wie bspw. Haushalts- oder Gartenscheren.

Das Handwerkzeug 1 weist zwei in einem Gelenkbereich kreuzend zueinander angeordnete Werkzeughälften 2, 3 auf. Hierbei formt jede Werkzeughälfte 2, 3 einen Griffbereich 4, 5, welcher jenseits des Kreuzungs- und Gelenkbereiches der Werkzeughälften 2, 3 in einen Arbeitsbereich 6, 7 übergeht. Die Arbeitsbereiche 6 und 7 formen in dem in Figur 1 dargestellten Ausführungsbeispiel eines Handwerkzeuges 1 Schneiden.

Der Griffbereich 4 und der Arbeitsbereich 6 bilden die Werkzeughälfte 2; Griffbereich 5 und Arbeitsbereich 7 die Werkzeughälfte 3.

Bevorzugt ist jeder Griffbereich 4, 5 umfasst von einer Griffhülle 8, 9. Hierbei kann es sich, wie bevorzugt, um eine aus einem Kunststoffmaterial gefertigte Hülle handeln, die ggf. unmittelbar an die Werkzeughälfte 2, 3 im Spritzverfahren angeformt ist. Bekannte Lösungen sehen hier die gesonderte Herstellung der Griffhüllen 8, 9 im Kunststoff-Spritzverfahren vor, ggf. im Zwei-Komponenten-Kunststoff-Spritzverfahren. Die Griffhüllen 8, 9 werden auf die Griffbereiche 4, 5 aufgeschoben. Auch können solche Griffhüllen 8, 9 vorliegen, die im Tauchvorgang unmittelbar an die Griffbereiche 4, 5 angeformt sind.

Insbesondere die aufeinander zu weisenden Innenflächen 10, 11 der Griffhüllen 8, 9 sind bevorzugt ausgehend von den freien Enden der Griffbereiche 4, 5 in Richtung auf das Gelenk 12 ebenflächig ausgebildet, dies weiter insbesondere in einem ausgehend von dem freien Ende der Griffbereiche 4, 5 ersten Viertel oder ersten Drittel der gesamten Längserstreckung der Griffhüllen 8, 9.

Eine solche ebene Fläche kann sich auch jeweils schenkelaußenseitig ergeben, weiter bspw. auch im Bereich der griffendseitigen Stirnflächen.

Jedenfalls ist der ebene Teilbereich der Innenflächen 10, 11 geeignet zur Anordnung eines zunächst gesondert vorliegenden Funktionsteiles 13.

Das Funktionsteil 13 kann, wie bevorzugt, ein gesondert hergestelltes Kunststoff-Spritzteil sein. Das Kunststoffmaterial kann bezüglich der Härte und/oder Farbgestaltung unterschiedlich gewählt sein zu dem Kunststoffmaterial im Bereich der die Befestigungszone anbietenden ebenen Fläche der Griffhülle 8, 9.

Das Funktionsteil 13 kann zur Anordnung an der Griffhülle 8, 9 angeklebt oder angeschweißt sein, wobei bei einem bevorzugten Ultraschallschweißen thermoplastische Kunststoffe sowohl hinsichtlich des Funktionsteils 13 als auch der Griffhülle 8, 9 im Befestigungsbereich vorliegen.

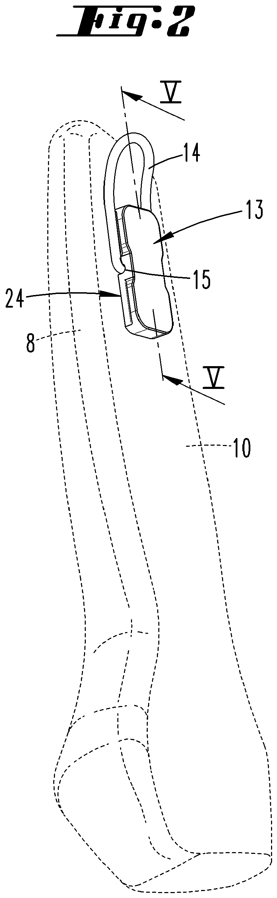

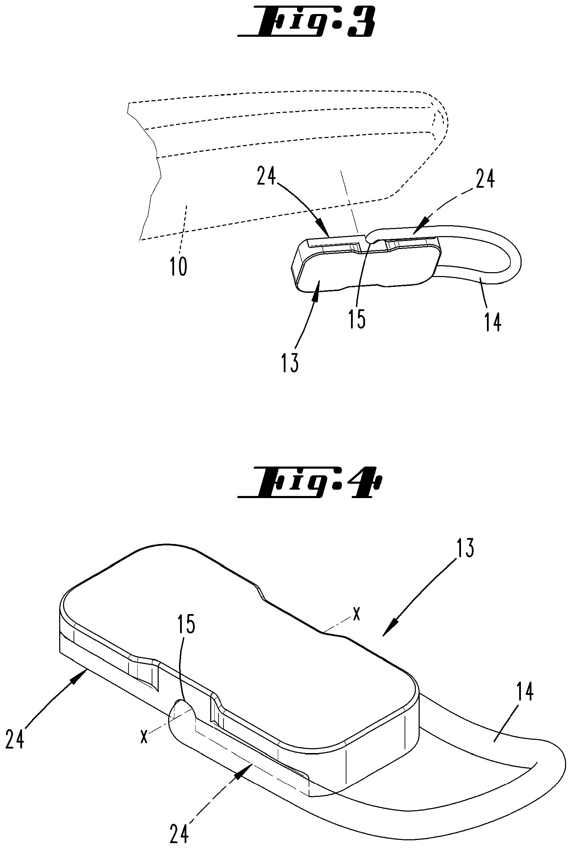

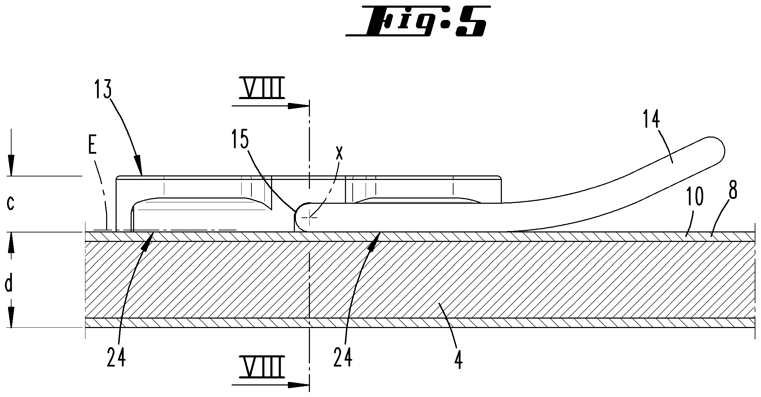

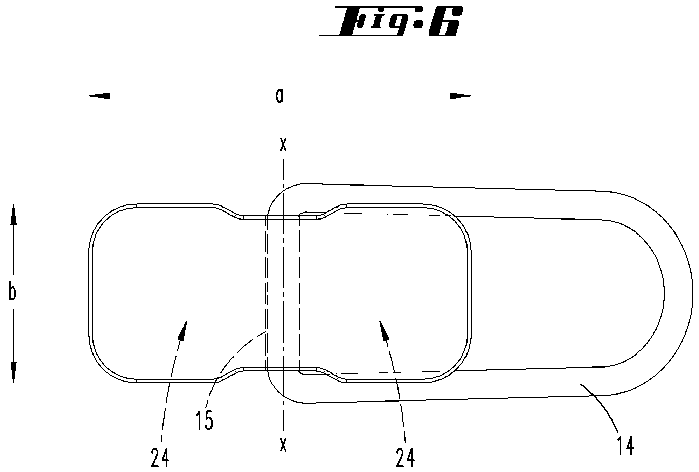

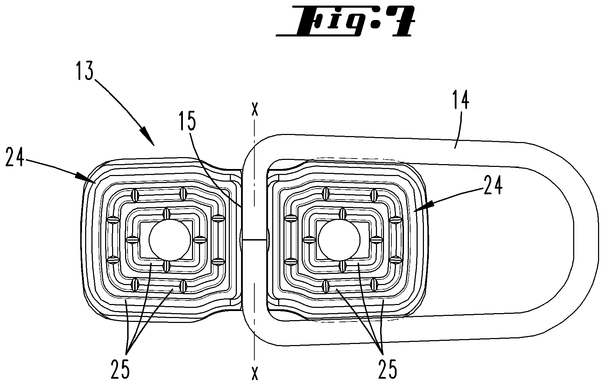

Das in den Figuren 1 bis 9 dargestellte Funktionsteil 13 ist ein Bügelhalter, entsprechend aufweisend einen um eine Achse x schwenkbaren, entsprechend gebogenen Drahtbügel 14. Die die geometrische Schwenkachse x bildenden Bügelschenkel erstrecken sich in einer in dem Funktionsteil 13 vorgesehenen Nut 15. Diese ist, in Zuordnungsstellung zugewandt der Oberfläche der Griffhülle 8 bzw. 9, geöffnet, so dass der Drahtbügel 14 zwischen der Griffhülle 8 bzw. 9 und dem Funktionsteil 13 gefangen ist.

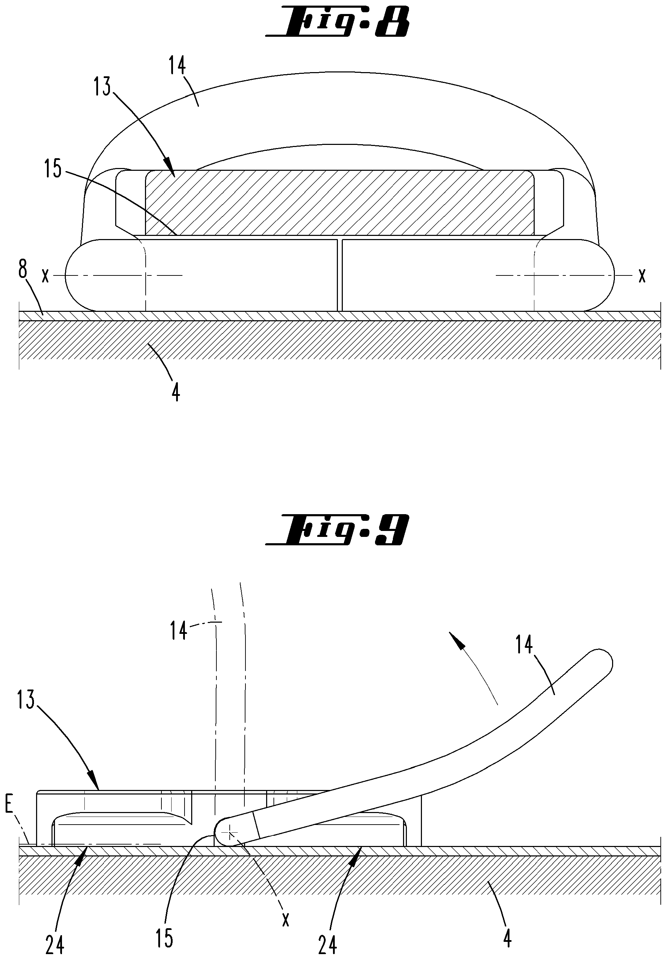

Bevorzugt stoßen die freien Enden des gebogenen Drahtbügels 14 innerhalb der Nut 15 aneinander (siehe Figur 8). Der Drahtbügel 14 kann unter Aufbiegung der diesbezüglichen freien Enden auch nachträglich an dem an der Griffhülle 8 bzw. 9 befestigten Funktionsteil 13 angeordnet werden. Durch die gesonderte Ausgestaltung des Funktionsteiles 13 und die offene Nut 15 kann auch ein quasi umlaufend endlos gestalteter Drahtbügel 14, bspw. mit verschweißten Enden, Verwendung finden. Ein solcher Drahtbügel 14 wird vor der Befestigung des Funktionsteiles 13 an der Griffhülle 8, 9 in die Nut 15 eingelegt.

Der Drahtbügel 14 kann bspw. in Verbindung mit einer Kordel o. dgl. zur Absturzsicherung des Handwerkzeuges 1 dienen, weiter bspw. durch Anbinden des Handwerkzeuges 1 an einen Gürtel o. dgl.

Die Kordel 16 kann bspw. mittels eines Ankerstiches eingeknotet sein.

Die gewählte Befestigung (Klebung oder Verschweißung) ist bevorzugt ausgelegt zur zerstörungsfreien Aufnahme von Kräften bis hin zu 300 oder 500 Newton.

Der bevorzugt aus einem rostfreien Federstahldraht bestehende Drahtbügel 14 kann in einer sich im Wesentlichen in Verlängerung des Funktionsteiles 13 erstreckenden Ausrichtung, wie diese auch in den Figuren 1 bis 8 dargestellt ist, im Wesentlichen feststehend sein. Eine Schwenkverlagerung des Drahtbügels 14 aus dieser Stellung heraus um die Schwenkachse x erfolgt bevorzugt erst nach Überlaufen einer konstruktiv vorgesehenen Überlast, bspw. etwa nach Aufschwenken des Drahtbügels 14 aus der Grundstellung heraus um etwa 15 bis 30° (vgl. Figur 9).

Wie weiter in Figur 9 in strichpunktierter Darstellung wiedergegeben, kann der Drahtbügel 14 in einer Ausführungsform auch in einer im Wesentlichen senkrecht zur Ausrichtung des Funktionsteiles 13 und somit bevorzugt auch senkrecht zur zugewandten Oberfläche der Innenfläche 10, 11 der Griffhülle 8, 9 weisenden Richtung rasthalterbar sein.

Dargestellt ist jeweils die Anordnung eines Funktionsteiles 13 an einer Innenfläche 10 oder 11 der Griffhüllen 8, 9. Möglich ist auch die Anordnung mehrerer Funktionsteile 13, bspw. zweier Funktionsteile 13 an beiden Griffhüllen 8, 9.

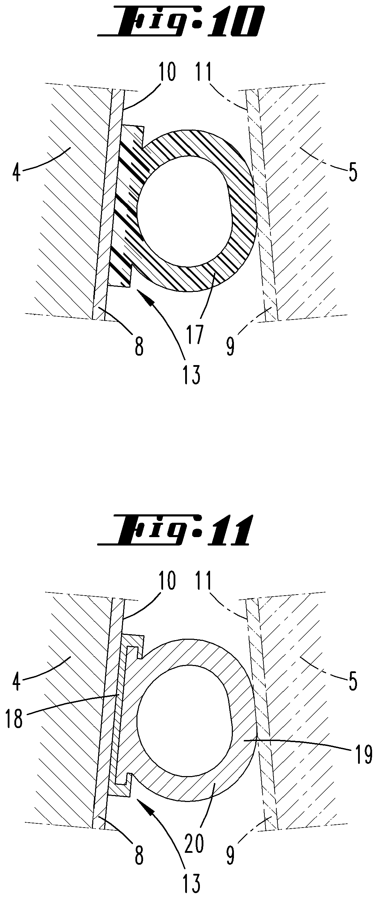

Wie weiter aus der Darstellung in Figur 10 zu erkennen, kann das Funktionsteil 13 auch eine Feder 17 sein. Hierzu ist das Funktionsteil 13 mit einem in dem Ausführungsbeispiel etwa kreisringförmigen elastischen Abschnitt ausgebildet (bspw. hergestellt im Zwei-Komponenten-Spritzverfahren). Über die Feder 17 stützt sich die eine Werkzeughälfte 2 an der anderen Werkzeughälfte 3 ab. Die Feder 17 unterstützt die selbsttätige Rückstellung des Handwerkzeuges 1 in eine bevorzugte Grundstellung.

Auch kann das Funktionsteil 13 einen Adapter 18 bilden, an welchem ein Aufschiebeteil 19 (ggf. ein Aufrastteil) anordbar ist. Der Adapter 18 ist mit unterschiedlichen Aufschiebeteilen 19 versehbar, so bspw., wie dargestellt, mit einem Federteil 20 (vgl. Figur 11).

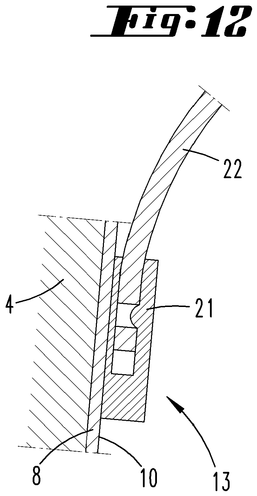

Auch kann das Funktionsteil 13 gemäß der Darstellung in Figur 12 eine Federaufnahme 21 sein, zur Halterung einer auf die andere Werkzeughälfte einwirkenden Blattfeder 22. Ein freies Ende der Blattfeder 22 kann in einer Schlitzaufnahme der Federaufnahme 21 gehaltert sein, insbesondere rastgehaltert.

Das Funktionsteil 13 weist einen zur Verbindung mit der Griffhülle 8 bzw. 9 ausgebildeten Verbindungsbereich 24 auf.

Dieser Verbindungsbereich 24 kann ebenflächig ausgebildet sein, bspw. zum Anbieten einer Klebefläche.

Bei einer, wie auch bevorzugten, Ultraschallverschweißung kann der Verbindungsbereich 24, insbesondere die der Oberfläche der Griffhülle 8, 9 zugewandte Verbindungsfläche rippen- oder noppenartig strukturiert sein. Dargestellt ist eine rippenartige Strukturierung mit konzentrisch zu einer im Wesentlichen senkrecht zur Verbindungsebene E verlaufenden Mittenachse umlaufend geschlossenen Rippen 25. In dem dargestellten Ausführungsbeispiel sind drei konzentrisch angeordnete, umlaufend geschlossene Rippen 25 in einem Verbindungsbereich 24 ausgebildet.

Es können, wie auch dargestellt, zwei in Längsrichtung der Griffhülle 8, 9 hintereinander angeordnete Verbindungsbereiche 24 vorgesehen sein, die bei einer Ausgestaltung des Funktionsteils 13 als Bügelhalter gemäß den Darstellungen in den Figuren 1 bis 9 durch die Nut 15 getrennt sind. Es ergeben sich in dem dargestellten Ausführungsbeispiel zwei im Grundriss etwa quadratische Verbindungsbereiche 24 mit jeweils drei konzentrisch umlaufenden Rippen 25.

Bei Funktionsteilen 13, deren Verbindungsfläche nicht durch eine Nut oder dergleichen unterbrochen ist, kann sich auch nur ein Verbindungsbereich 24 einstellen, bspw. ein langgestreckt rechteckiger Verbindungsbereich.

Insgesamt ergibt sich insbesondere bei dem Funktionsteil 13 der ersten Ausführungsform eine langgestreckt, quaderförmige Gestaltung mit einer in Längserstreckung der Griffhülle 8, 9 betrachteten Länge a, die etwa dem 1,5- bis 3-Fachen, bevorzugt etwa dem 2-Fachen der quer hierzu betrachteten Breite b des Funktionsteiles 13 entspricht.

Die senkrecht zur Verbindungsebene E betrachtete Dicke c des Funktionsteiles 13 entspricht etwa einem Drittel bis zwei Drittel, bspw. etwa der Hälfte des von der Griffhülle 8, 9 im Übrigen umschlossenen Griffbereiches 4, 5 im Bereich des Funktionsteiles 13 gegebenen Dicke d.

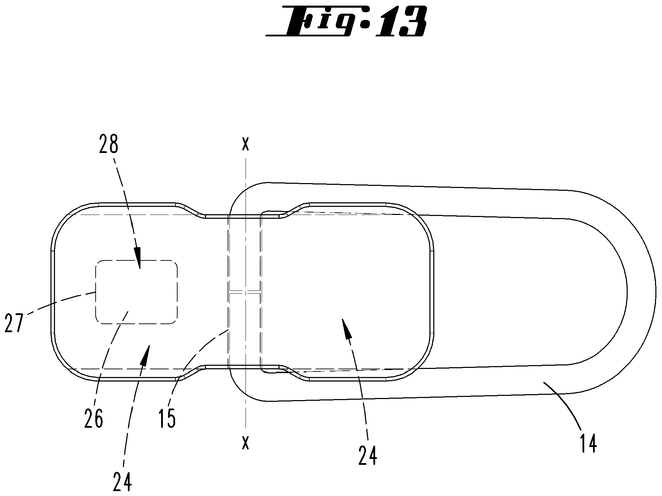

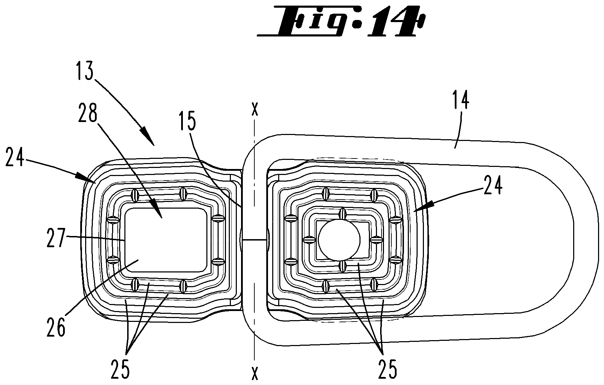

Die Figuren 13 bis 16 zeigen Ausführungsformen, bei denen unter Nutzung des Funktionsteils 13 ein Technikteil 28, insbesondere elektronisches Technikteil, wie bspw. ein Transponder 26, insbesondere ein RFID-Transponder, an dem Griffbereich bzw. an der Griffhülle angeordnet ist.

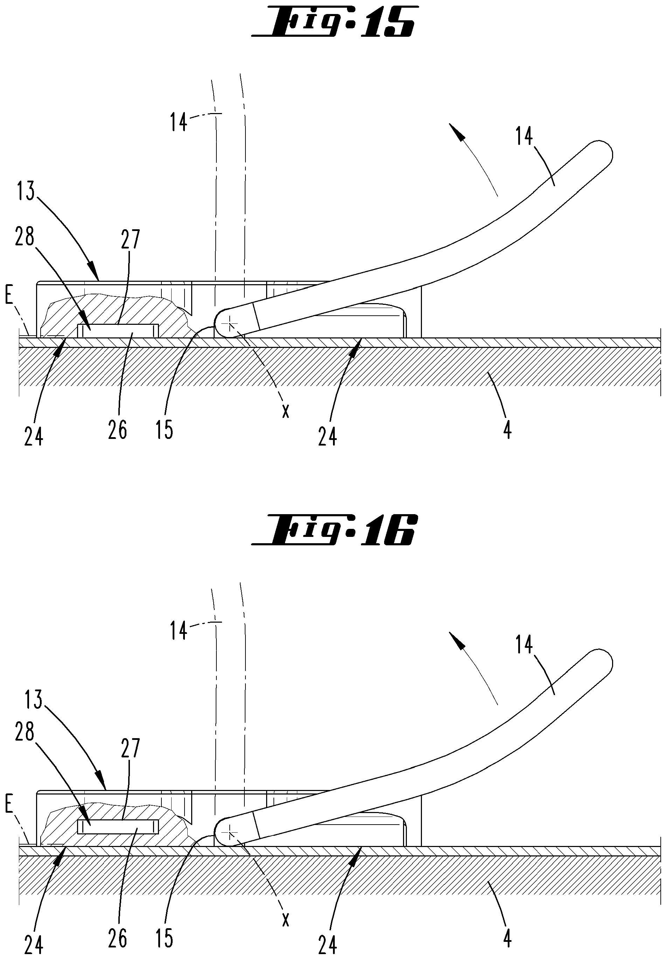

Der Transponder 26 kann von dem Material, insbesondere Kunststoffmaterial, des Funktionsteils 13 umschlossen sein (vgl. Figur 16).

Eine solche Verstecktlage des Transponders 26 kann gegeben sein bei einer Ausgestaltung gemäß den Figuren 13 bis 15, bei welcher in einem Verbindungsbereich 24 eine zur Verbindungsebene E hin offene, ansonsten rundum geschlossene Ausnehmung 27 vorgesehen ist, in welche der Transponder 26 einsetzbar ist. Nach Befestigung des Funktionsteils 13 ist der Transponder 26 gefangen zwischen Funktionsteil 13 und Griff.

Ein solches Technikteil 28 kann auch bspw. ein Spannungsprüfer sein oder auch weiter bspw. ein aufladbarer Akkumulator zum Betreiben eines elektrischen oder elektronischen Elementes.

**Liste der Bezugszeichen**

| | | | |
|---|---|---|---|
| 1 | Handwerkzeug | 23 | Schlitzaufnahme |
| 2 | Werkzeughälfte | 24 | Verbindungsbereich |
| 3 | Werkzeughälfte | 25 | Rippe |
| 4 | Griffbereich | 26 | Transponder |
| 5 | Griffbereich | 27 | Ausnehmung |
| 6 | Arbeitsbereich | 28 | Technikteil |
| 7 | Arbeitsbereich | | |
| 8 | Griffhülle | | |
| 9 | Griffhülle | E | Verbindungsebene |
| 10 | Innenfläche | | |
| 11 | Innenfläche | | |
| 12 | Gelenk | | |
| 13 | Funktionsteil | | |
| 14 | Drahtbügel | a | Länge |
| 15 | Nut | b | Breite |
| 16 | Kordel | c | Dicke |
| 17 | Feder | d | Dicke |
| 18 | Adapter | x | Schwenkachse |
| 19 | Aufschiebeteil | | |
| 20 | Federteil | | |
| 21 | Federaufnahme | | |
| 22 | Blattfeder | | |

## Patentansprüche

1. Handwerkzeug (1) mit zwei in einem Gelenkbereich kreuzend zueinander angeordneten Werkzeughälften (2, 3), wie bspw. Zange oder Schere, wobei eine Werkzeughälfte (2, 3) auf einer Seite des Gelenkbereiches einen Arbeitsbereich (6, 7) ausbildet und auf der anderen Seite einen Griffbereich (4, 5), wobei weiter jeder Griffbereich (4, 5) in einer ersten bzw. zweiten Griffhülle (8, 9) angeordnet ist und die Griffhülle (8, 9) mit einem, bezogen auf eine sich über einen wesentlichen Teil der Oberfläche der Griffhülle (8, 9) erstreckende ebene Fläche, überstehenden Funktionsteil (13) versehen ist, **dadurch gekennzeichnet, dass** aufeinander zu weisende Innenflächen der Griffhüllen (8, 9), ausgehend von freien Enden der Griffbereiche (4, 5), ebenflächig ausgebildet sind, dass das Funktionsteil (13) auf der der Innenfläche (10, 11) der gegenüberliegenden zweiten und/oder ersten Griffhülle (8, 9) zugewandten Innenfläche (10, 11) der ersten und/oder zweiten Griffhülle (8, 9) angeordnet ist, und dass das Funktionsteil (13) angeklebt oder angeschweißt ist, an einer Position, welche außerhalb eines Erfassungs- und Einwirkungsbereiches des Benutzers liegt.

2. Handwerkszeug nach Anspruch 1, **dadurch gekennzeichnet, dass** das Funktionsteil (13) einen zur Verbindung mit der ersten und/oder zweiten Griffhülle (8, 9) ausgebildeten Verbindungsbereich (24) aufweist, der als ebene Fläche oder rippen- oder noppenartig strukturiert ausgebildet ist.

3. Handwerkzeug nach Anspruch 2, **dadurch gekennzeichnet, dass** im Falle einer rippenartigen Strukturierung mindestens eine umlaufend geschlossene Rippe (25) ausgebildet ist.

4. Handwerkzeug nach einem der vorhergehenden Ansprüche, **dadurch gekennzeichnet, dass** zwei in Längsrichtung einer Griffhülle (8, 9) gesonderte Verbindungsbereiche (24) ausgebildet sind.

5. Handwerkzeug nach einem der vorhergehenden Ansprüche, **dadurch gekennzeichnet, dass** das Funktionsteil (13) insgesamt eine langgestreckt, quaderförmige Gestaltung aufweist.

6. Handwerkzeug nach einem der vorhergehenden Ansprüche, **dadurch gekennzeichnet, dass** das Funktionsteil (13) eine über die ebene Fläche der Oberfläche überstehende Dicke (c) aufweist, die 1/10 bis 2/3 der Dickenabmessung des von der Griffhülle (8, 9) im Übrigen umschlossenen Griffbereiches (4, 5) im Bereich des Funktionsteiles (13) entspricht.

7. Handwerkzeug nach einem der vorhergehenden Ansprüche, **dadurch gekennzeichnet, dass** das Funktionsteil (13) als Fallsicherung ausgebildet ist, eine Feder (17) oder eine Federaufnahme (21) ist oder ein Bügelhalter, ein Adapter (18) für ein Aufschiebe- oder Aufrastteil (19) oder eine Aufnahme oder Halterung für ein Technikteil (28).

8. Handwerkzeug nach Anspruch 7, **dadurch gekennzeichnet, dass** das Technikteil (28) ein RFID-Transponder (26) ist.

9. Handwerkzeug nach Anspruch 7 oder 8, **dadurch gekennzeichnet, dass** das Technikteil (28) ein Spannungsprüfer ist.

## Claims

1. Hand tool (1) with two tool halves (2, 3), arranged crossing one another in a joint region, such as pliers or scissors, wherein a tool half (2, 3) forms a working region (6, 7) on one side of the joint region, and on the other side a gripping region (4, 5), wherein furthermore, each gripping region (4, 5) is arranged in a first and a second gripping sleeve (8, 9), respectively, and the gripping sleeve (8, 9) is provided with a functional part (13), projecting with respect to a flat surface extending over a substantial part of the surface of the gripping sleeve (8, 9), **characterised in that**, inner surfaces of the gripping sleeves (8, 9) facing one another are designed with flat surfaces originating from free ends of the gripping regions (4, 5), **in that**, the functional part (13) is arranged on the inner surface (10, 11) of the first and/or second gripping sleeve (8, 9) facing the inner surface (10, 11) of the opposing second and/or first gripping sleeve (8, 9), and **in that**, the functional part (13) is adhesively bonded, or welded, onto a position that lies outside an acquisition and action region of the user.

2. Hand tool according to Claim 1, **characterised in that**, the functional part (13) has a connecting region, designed for connection to the first and/or second gripping sleeve (8, 9), which connecting region (24) is designed as a flat surface, or is designed with a ribbed or knobbled structure.

3. Hand tool according to Claim 2, **characterised in that**, in the case of a ribbed structure, at least one peripherally closed rib (25) is formed.

4. Hand tool according to one of the preceding claims, **characterised in that**, two separate connecting regions (24) are designed in the longitudinal direction of a gripping sleeve (8, 9).

5. Hand tool according to one of the preceding claims, **characterised in that**, the functional part (13) has an elongated, cuboid shape overall.

6. Hand tool according to one of the preceding claims, **characterised in that**, the functional part (13) has a thickness (c) projecting above the plane surface of the surface, which thickness corresponds to 1/10 to 2/3 of the thickness dimension of the gripping region (4, 5) otherwise enclosed by the gripping sleeve (8, 9) in the region of the functional part (13).

7. Hand tool according to one of the preceding claims, **characterised in that**, the functional part (13) is designed as a drop guard, is a spring (17) or a spring holder (21), or is a clip holder, an adapter (18) for a push-on or snap-on part (19), or a holder or mounting for a technology item (28).

8. Hand tool according to Claim 7, **characterised in that**, the technology item (28) is an RFID transponder (26).

9. Hand tool according to Claim 7 or 8, **characterised in that**, the technology item (28) is a voltage tester.

## Revendications

1. Outil à main (1) avec deux moitiés d'outil (2, 3) agencées de manière à se croiser dans une région d'articulation, telle qu'une pince ou des ciseaux, dans lequel une moitié d'outil (2, 3) forme d'un côté de la région d'articulation une région de travail (6, 7) et de l'autre côté une région de poignée (4, 5), dans lequel en outre chaque région de poignée (4, 5) est agencée dans une première et une deuxième gaine de poignée (8, 9) respectivement et la gaine de poignée (8, 9) est pourvue d'une partie fonctionnelle (13) faisant saillie par rapport à une surface plate s'étendant sur une partie substantielle de la surface de la gaine de poignée (8, 9), **caractérisé en ce que** les surfaces intérieures des gaines de poignée (8, 9) se faisant face sont formées avec une surface plate à partir des extrémités libres des régions de poignée (4, 5), **en ce que** la partie fonctionnelle (13) est agencée sur la surface intérieure (10, 11) de la première et/ou deuxième gaine de poignée (8, 9) qui fait face à la surface intérieure (10, 11) de la deuxième et/ou première gaine de poignée (8, 9) opposée et **en ce que** la partie fonctionnelle (13) est collée ou soudée à une position qui se trouve en dehors d'une zone de perception et d'action de l'utilisateur.

2. Outil à main selon la revendication 1, **caractérisé en ce que** la partie fonctionnelle (13) présente une région de raccordement (24) conçue pour le raccordement à la première et/ou à la deuxième gaine de poignée (8, 9) et qui est conçue en tant que surface plane ou est structurée à la manière de nervures ou de picots.

3. Outil à main selon la revendication 2, **caractérisé en ce que** dans le cas d'une structuration à la manière de nervures est formée au moins une nervure (25) fermée en direction périphérique.

4. Outil à main selon l'une des revendications précédentes, **caractérisé en ce que** sont formées deux régions de raccordement (24) qui sont séparées dans la direction longitudinale d'une gaine de poignée (8, 9).

5. Outil à main selon l'une des revendications précédentes, **caractérisé en ce que** la partie fonctionnelle (13) présente dans son ensemble une forme allongée et parallélépipédique.

6. Outil à main selon l'une des revendications précédentes, **caractérisé en ce que** la partie fonctionnelle (13) présente une épaisseur (c) dépassant de la surface plane qui correspond à 1/10 à 2/3 de la dimension de l'épaisseur de la région de poignée (4, 5), entourée par ailleurs par la gaine de préhension (8, 9), dans la zone de la partie fonctionnelle (13).

7. Outil à main selon l'une des revendications précédentes, **caractérisé en ce que** la partie fonctionnelle (13) est conçue comme une protection contre les chutes, est un ressort (17) ou un logement de ressort (21), ou est un support d'étrier, un adaptateur (18) pour une partie emboîtable ou encliquetable (19) ou un logement ou une fixation pour une pièce technique (28).

8. Outil à main selon la revendication 7, **caractérisé en ce que** la partie technique (28) est un transpondeur RFID (26).

9. Outil à main selon la revendication 7 ou 8, **caractérisé en ce que** la partie technique (28) est un testeur de tension.
